# FASCICULE DE BREVET EUROPEEN

(11) **EP 1 121 622 B1**
(45) Date de publication et mention de la délivrance du brevet: **06.08.2008**
(21) Numéro de dépôt: 00958643.9
(22) Date de dépôt: 28.07.2000
(51) Int. Cl.: G03F 1/14, G02B 5/08

(54) **STRUCTURE POUR MASQUE DE LITHOGRAPHIE EN REFLEXION ET PROCEDE POUR SA REALISATION**
REFLEXIONSMASKE FÜR DIE PHOTOLITHOGRAPHIE UND VERFAHREN ZU DEREN HERSTELLUNG
STRUCTURE FOR REFLECTION LITHOGRAPHY MASK AND METHOD FOR MAKING SAME

(30) Priorité: 29.07.1999 FR 9909842
(43) Date de publication de la demande: 08.08.2001
(73) Titulaire: COMMISSARIAT A L'ENERGIE ATOMIQUE, 75015 Paris (FR)
(72) Inventeur: ROBIC, Jean-Yves, F-38100 Grenoble (FR); ASPAR, Bernard, F-38140 Rives (FR)
(74) Mandataire: Brykman, Georges
(86) Numéro de dépôt international: PCT/FR2000/002176
(87) Numéro de publication internationale: WO 2001/009680

(56) Documents cités:
- PEI-YANG YAN ET AL: "EUV mask patterning approaches" , EMERGING LITHOGRAPHIC TECHNOLOGIES III, SANTA CLARA, CA, USA, 15-17 MARCH 1999 , PROCEEDINGS OF THE SPIE - THE INTERNATIONAL SOCIETY FOR OPTICAL ENGINEERING, 1999, SPIE-INT. SOC. OPT. ENG, USA, PAGE(S) 309 - 313 XP002135877 ISSN: 0277-786X

## Description

### Domaine technique

La présente invention concerne une structure pour masque de lithographie en réflexion, en particulier pour la lithographie extrême ultra-violet (EUV). Un tel masque est utilisable notamment pour la réalisation de circuits intégrés.

L'invention concerne aussi un procédé pour la réalisation d'une structure pour masque de lithographie en réflexion.

### Etat de la technique antérieure

La lithographie ou photo-lithographie est le procédé qui permet de transférer l'image d'un masque dans une couche de résine photo-sensible déposée sur un échantillon. Cette étape d'insolation d'une résine au travers d'un masque, à l'aide d'une source de lumière et d'un système optique, est réalisée sur un équipement dénommé photo-masqueur. Après insolation, la résine est révélée permettant ainsi d'obtenir sur l'échantillon un masque de résine qui servira pour les étapes nécessaires à la réalisation de dispositif micro-électronique (masque à la gravure, masque au dépôt ou masque à l'implantation ionique).

Les progrès de la lithographie optique ont été le facteur-clé de la croissance de l'industrie des circuits intégrés (CI) toutes ces dernières années, le principal vecteur d'amélioration étant l'utilisation d'une longueur d'onde de plus en plus courte pour l'insolation des résines. Ainsi, la lithographie est passée de 365 nm à 248 nm et aujourd'hui 193 nm, la diminution de la longueur d'onde permettant de réduire les dimensions critiques des CI jusqu'à atteindre des dimensions de l'ordre du dixième de µm. Ces progrès techniques et la disponibilité, à temps, des équipements de production pour la photo-lithographie, des masques et des résines ont permis, depuis 30 ans, à l'industrie de la micro-électronique de poursuivre sa croissance conformément à la loi de Moore.

Cependant, la poursuite de la miniaturisation des circuits intégrés avec des motifs sub-0,1 µm nécessite une nouvelle approche technologique en rupture avec la lithographie optique. En effet, les matériaux réfractifs couramment utilisés pour la lithographie optique deviennent trop absorbants pour les longueurs d'onde inférieures à 190 nm. Différentes solutions regroupées sous le nom de nouvelle génération lithographie (New Generation Lithography en anglais ou NGL) ont été proposées. L'enjeu est capital pour l'industrie des semi-conducteurs.

Parmi les NGL, la Lithographie Extrême Ultra-Violet (EUV) utilisant des longueurs d'onde comprises entre 10 et 14 nm (rayonnement X mou) est une des voies les plus prometteuses. A ces courtes longueurs d'onde, une résolution inférieure à 0,1 µm peut être obtenue, tout en gardant une ouverture numérique faible et une profondeur de champ supérieure à 1 µm. Cette technologie peut satisfaire plusieurs générations technologiques sub-0,1 µm jusqu'à la génération 256 Gbit prévue en production en 2012 par la Semiconductor Industry Association (SIA). La lithographie EUV est la solution choisie en priorité par l'association internationale des industries des semi-conducteurs (International Sematech). Des travaux importants sont en cours à ce sujet aux Etats-Unis, au Japon et en Europe.

Les défis technologiques posés par la mise en oeuvre d'une lithographie dans l'extrême ultra-violet concernent particulièrement cinq aspects : la source de rayonnement EUV, l'optique de projection du photo-masqueur, les masques, les procédés résine et la métrologie associée au développement des optiques et des masques.

Contrairement aux masques actuels de lithographie optique (masques en transmission réalisés par un dépôt de chrome sur un support en quartz) un masque pour la lithographie EUV est un masque en réflexion et non plus en transmission.

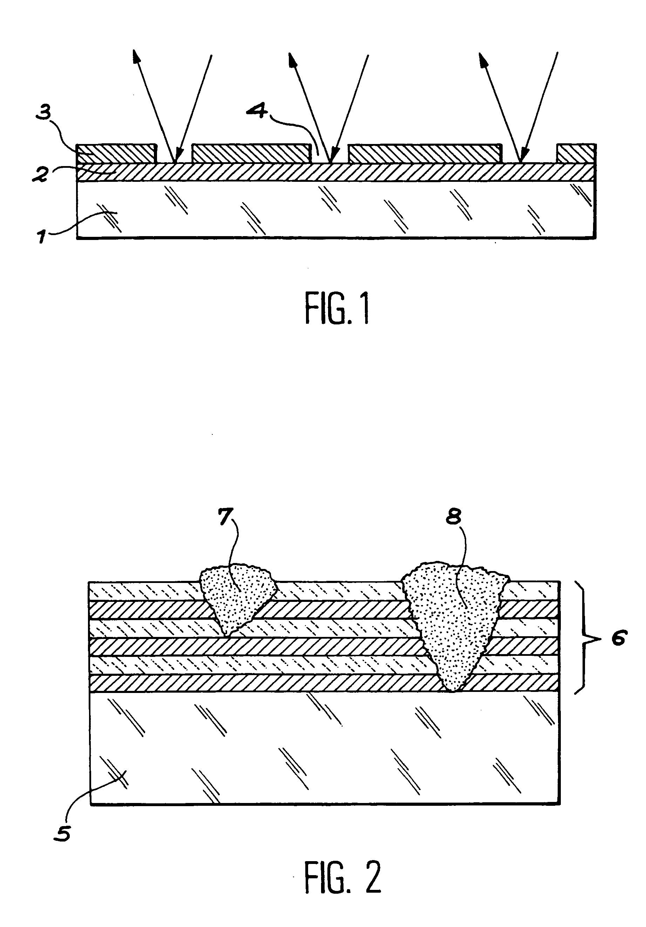

La figure 1 est une vue en coupe transversale d'un masque EUV selon l'art connu. Ce masque se compose d'un substrat 1 sur lequel est déposé un revêtement réflecteur 2 qui est à son tour recouvert d'une couche absorbante 3. Le motif à projeter sur la résine à insoler est formé sur le masque par gravure de la couche absorbante 3. Ainsi, seules les zones gravées 4 seront réfléchissantes et viendront s'inscrire lors de la projection lithographique comme indiqué par les flèches sur la figure 1.

Le substrat 1 peut être une plaquette de silicium de 200 mm de diamètre. D'autres substrats peuvent être envisagés afin de tenir compte des problèmes de stabilité sous flux lumineux, par exemple un verre à faible coefficient de dilatation.

Le réflecteur 2 est constitué d'un empilement de multicouches. Un grand facteur de réflexion est obtenu à l'aide d'une structure interférentielle de multicouches et par le bon choix des matériaux constituant les multicouches. Le molybdène et le silicium offrent de bonnes performances à la longueur d'onde de 13 nm et des facteurs de réflexion supérieures à 65% peuvent être obtenus avec environ une quarantaine de multicouches, chaque multicouche étant formée d'une couche de molybdène et d'une couche de silicium. D'autres couches de matériaux sont envisageables comme par exemple Mo/Be ou encore Ru/Be.

La couche absorbante 3 doit être absorbante dans la gamme spectrale de l'EUV, notamment autour de 13 nm. Les matériaux utilisables pour la constituer sont nombreux. Les matériaux utilisés en micro-électronique (comme Ti, Ta, TaSi, TiW, W, Cr, TiN, Al) sont préférés. Pour une optique ayant un facteur de réduction de 4, la taille du motif gravé dans la couche absorbante sera quatre fois plus grande que le motif insolé sur le circuit. On parle de réticule à l'échelle 4X.

Pour tenir les spécifications liées à l'étape d'insolation, c'est-à-dire imprimer sur la résine insolée un motif de bonne définition géométrique, conservant les dimensions souhaitées sur toute la zone insolée et sans défauts, la réalisation du masque doit répondre à certaines conditions. Le masque doit posséder une excellente planéité, avec typiquement des valeurs de déformation inférieures à 0,4 µm pour un diamètre de 200 mm. Son coefficient de réflexion doit être suffisant pour garantir la dose de rayonnement EUV nécessaire à l'insolation, soit un coefficient de réflexion supérieur à 60%. La couche absorbante doit être réalisée (dépôt et gravure) conformément à la géométrie souhaitée. Le taux de défauts en surface du masque doit être extrêmement faible, de l'ordre de quelques 10⁻³ défauts/cm², pour des défauts de dimensions égales ou supérieures à 50 nm environ. Le multicouche et la couche absorbante qui constituent le masque sont situés au plan objet du système optique. En conséquence, toute variation significative de phase ou d'amplitude du champ réfléchi par le masque peut potentiellement être répliqué par le procédé de lithographie et peut ainsi imprimer un défaut rédhibitoire dans la résine. S'il existe des procédés pour réparer les défauts de la couche absorbante, il n'existe pas de solution satisfaisante pour réparer les défauts dans le multicouche réflecteur. Cette dernière condition reste le problème majeur pour la maîtrise de la réalisation des masques. Les meilleurs résultats obtenus sont de quelques 10⁻² défauts/cm².

Les spécifications des masques, en terme de contrôle de forme et de défauts, impliquent la maîtrise technologique de toutes les étapes de réalisation de celui-ci. L'élaboration des masques se fait en deux grandes étapes :
- la réalisation du substrat réflecteur multicouche appelé "mask blank" dans la littérature spécialisée anglo-saxonne,
- la réalisation du réticule (appelé "mask patterning" en anglais), c'est-à-dire la réalisation de la couche absorbante gravée sur le substrat réflecteur multicouche.

Plusieurs approches ont été proposées pour la réalisation des masques : un procédé par gravure directe de la couche absorbante, un procédé par lift-off (voir l'article de H. KINOSHITA et al., "Mask technology of extreme ultraviolet lithography", SPIE vol. 3412, 358-368) et un procédé de type damascène.

Le procédé par gravure directe de la couche absorbante comprend les étapes de base suivantes :
- dépôt du multicouche réflecteur sur un substrat,
- dépôts éventuels de couches de protection et/ou tampon (couches intermédiaires),
- dépôt de la couche absorbante par un procédé similaire à celui du dépôt d'une couche métallique en micro-électronique,
- étape de lithographie (étalement d'une résine, insolation, développement) pour délimiter les zones à graver,
- gravure sélective de la couche absorbante, des couches intermédiaires pouvant être nécessaires entre la couche absorbante et le multicouche réflecteur pour permettre la gravure sélective et protéger le multicouche,
- élimination partielle ou totale par gravure des couches intermédiaires, en fonction de la nature desdites couches et de leur transparence à la longueur d'onde utilisée, dans les zones gravées de la couche absorbante.

Le procédé de type damascène comprend les étapes suivantes :
- dépôt du multicouche récepteur sur un substrat,
- dépôt et gravure d'une autre couche,
- dépôt de la couche absorbante et élimination de ladite couche au-dessus des motifs non gravés de la couche précédente.

La difficulté majeure des procédés actuels réside dans la présence de défauts à la surface du multicouche réflecteur dont la dimension est supérieure à une dimension critique. Ces défauts trouvent leurs originels :
- dans des défauts de croissance liés à des défauts ou des imperfections du support (substrat),
- dans des défauts générés au cours de l'élaboration de l'empilement multicouches (pollution par des particules au cours du dépôt ou des défauts de croissance à chaque interface du multicouche).

Les défauts des couches minces, et des multicouches a fortiori, peuvent être générés par de très petits défauts. La dimension des défauts croît, par effet d'ombrage, avec l'épaisseur de dépôt les recouvrant à mesure de l'élaboration du multicouche. Initiés sur des défauts de dimension non critique, les défauts peuvent en surface dépasser la dimension critique. La dimension critique va dépendre de l'application.

La figure 2 est une vue en coupe transversale d'un substrat 5 recouvert d'une succession de couches destinées à constituer le multicouche réflecteur 6 d'un masque selon l'art connu. Les références 7 et 8 représentent des défauts initialement de dimensions non critiques et qui se sont développés jusqu'à dépasser la dimension critique.

### Exposé de l'invention

Pour remédier à ce problème de l'art antérieur, il est proposé selon la présente invention d'inverser la structure du multicouche de sorte que la première couche du multicouche (celle réalisée en premier lors de son élaboration) soit celle positionnée en face avant (face éclairée) dans la structure finale du masque et non le contraire comme dans les structures de l'art connu. L'avantage de cette solution est que les défauts apparents en surface de la structure finale du masque seront plus petits et moins nombreux. La perturbation par les défauts de l'onde réfléchie va être réduite. Et ceci du fait que, dans un système réflecteur de multicouches interférentielles, la contribution à la réflexion totale des différentes ondes réfléchies par chaque interface du multicouche décroît à mesure que l'interface considérée est située loin de la surface.

Un premier objet de l'invention est constitué par une structure pour masque de lithographie en réflexion comportant un support de réception sur lequel est fixé un réflecteur comprenant au moins une couche, le réflecteur étant fixé au support de réception de manière inversée par rapport à un support de fabrication sur lequel il a été précédemment fabriqué.

De préférence, le réflecteur est un multicouche, par exemple formé d'une alternance de couches de molybdène et de silicium. D'autres matériaux de l'art antérieur peuvent bien sûr être utilisés.

Le réflecteur peut être fixé au support de réception par l'intermédiaire d'une couche d'adhérence.

Si le réflecteur a été fabriqué sur un support de fabrication recouvert d'une couche absorbante pour la longueur d'onde de la source de rayonnement de lithographie utilisé, le réflecteur et la couche absorbante peuvent être fixés au support de réception de manière inversée par rapport au support de fabrication. Eventuellement, la couche absorbante recouvrant le support de fabrication est une couche gravée selon un motif de masque désiré.

Ainsi, les motifs de la couche absorbante de la structure pour masque selon l'invention peuvent être réalisés selon les procédés directs ou de type damascène définis précédemment. Ces motifs peuvent être réalisés soit avant la formation du réflecteur sur le support de fabrication comme indiqué ci-dessus, soit après la formation du réflecteur et son transfert sur le support de réception.

Le support de réception peut être un substrat de silice vitreuse ou d'un autre matériau à faible coefficient de dilatation.

Un deuxième objet de l'invention est constitué par un procédé de réalisation d'une structure pour masque de lithographie en réflexion, caractérisé en ce qu'il comporte les étapes suivantes :
- réalisation d'un réflecteur sur un support de fabrication,
- fixation d'un support de réception sur le réflecteur,
- élimination au moins partielle du support de fabrication.

Le réflecteur peut être réalisé sous forme d'un multicouche.

Le procédé peut comprendre une étape préliminaire de formation d'une couche absorbante, pour la longueur d'onde de la source de rayonnement de lithographie utilisé, sur le support de fabrication avant la réalisation du réflecteur.

La fixation du support de réception sur le réflecteur peut se faire par adhésion moléculaire. Avantageusement, une couche d'adhérence est utilisée pour fixer le support de réception sur le réflecteur.

Selon une variante de mise en oeuvre, l'élimination du support de fabrication s'effectue par amincissement mécanique et/ou mécano-chimique et/ou chimique. Eventuellement, le support de fabrication étant pourvu, côté réflecteur, d'une couche d'arrêt, l'amincissement s'effectue jusqu'au contact avec la couche d'arrêt. L'élimination du support de fabrication utilisant l'amincissement mécanique, celui-ci peut être arrêté avant élimination complète du support de fabrication, l'élimination étant poursuivie ensuite par voie chimique.

Selon une autre variante de mise en oeuvre, le support de fabrication comportant, côté réflecteur, une couche sacrificielle, l'élimination du support de fabrication se fait par gravure sélective de la couche sacrificielle.

Selon encore une autre variante de mise en oeuvre, le support de fabrication est un substrat dont une face, destinée à être située côté réflecteur, a été implantée par des espèces gazeuses afin de former une couche de microcavités dans le substrat et à proximité de la face implantée, l'élimination du support de fabrication comprenant l'application d'un recuit et/ou de force mécanique pour obtenir le clivage du substrat de fabrication le long de la couche de microcavités. Il subsiste alors un film mince. La couche d'arrêt ou le film mince peuvent être ensuite éliminés totalement ou partiellement suivant les variantes de l'invention, c'est-à-dire totalement dans le cas où le transfert sur le support de réception se fait avec les motifs absorbants et totalement ou partiellement dans le cas où les motifs absorbants sont réalisés après transfert de la couche de réflexion.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue en coupe transversale d'un masque EUV selon l'art connu,
- la figure 2 est une vue en coupe transversale d'une structure pour masque de lithographie en réflexion selon l'art connu où des défauts sont mis en évidence,
- les figures 3A à 3C illustrent, dans son principe, le procédé de réalisation d'une structure pour masque de lithographie en réflexion selon l'invention,
- les figures 4A à 4C illustrent une première variante du procédé de réalisation d'une structure pour masque de lithographie en réflexion selon l'invention,
- les figures 5A à 5H illustrent une deuxième variante du procédé de réalisation d'une structure pour masque de lithographie en réflexion selon l'invention.

### Description détaillée de modes de réalisation de l'invention

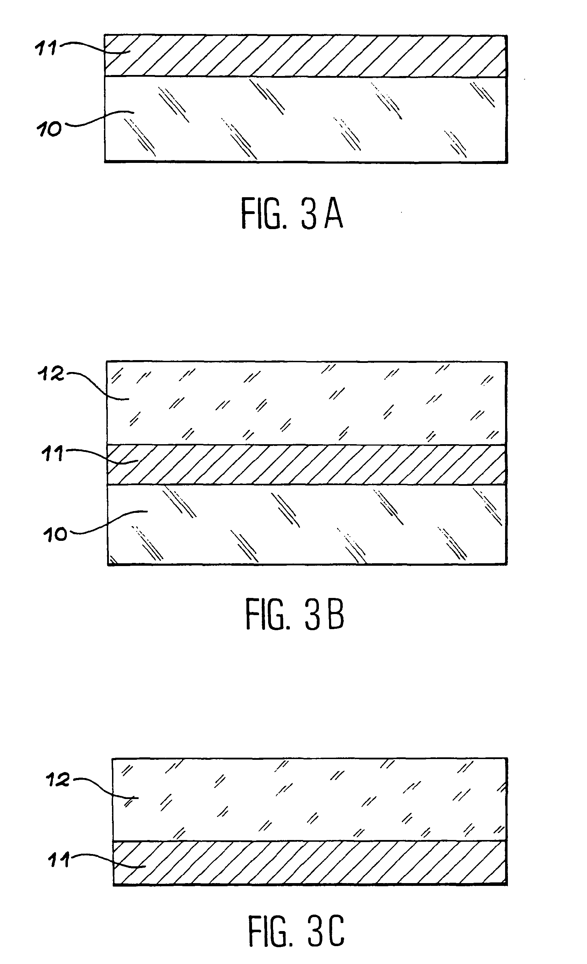

Le principe du procédé de réalisation selon l'invention d'une structure pour masque de lithographie en réflexion est présentée aux figures 3A à 3C.

La figure 3A montre, en coupe transversale, un support de fabrication 10 recouvert sur l'une de ses faces principales par un réflecteur 11 constitué d'une ou de plusieurs couches. Le réflecteur présente une face libre sur laquelle est fixé un support de réception 12 (voir la figure 3B). Après élimination du support de fabrication, comme le montre la figure 3C, on obtient un support de réception 12 auquel est fixé le réflecteur 11.

En fonction de sa constitution, le support de fabrication peut être éliminé de plusieurs manières différentes. Si ce support est monolithique, il peut être éliminé par abrasion ou par polissage mécano-chimique. Si ce support comporte, côté réflecteur, une couche sacrificielle apte à être gravée sélectivement par rapport aux autres éléments de l'assemblage représenté à la figure 3B, cette couche sacrificielle peut être gravée sélectivement pour récupérer le reste du support de fabrication. Si le support de fabrication comporte une zone de clivage obtenue par implantation ionique selon l'enseignement du document FR-A-2 681 472, un traitement thermique adapté et/ou l'utilisation de force mécanique permet la séparation de la majeure partie du support de fabrication, le film mince subsistant sur le réflecteur pouvant être ensuite enlevé, totalement ou partiellement, ou conservé.

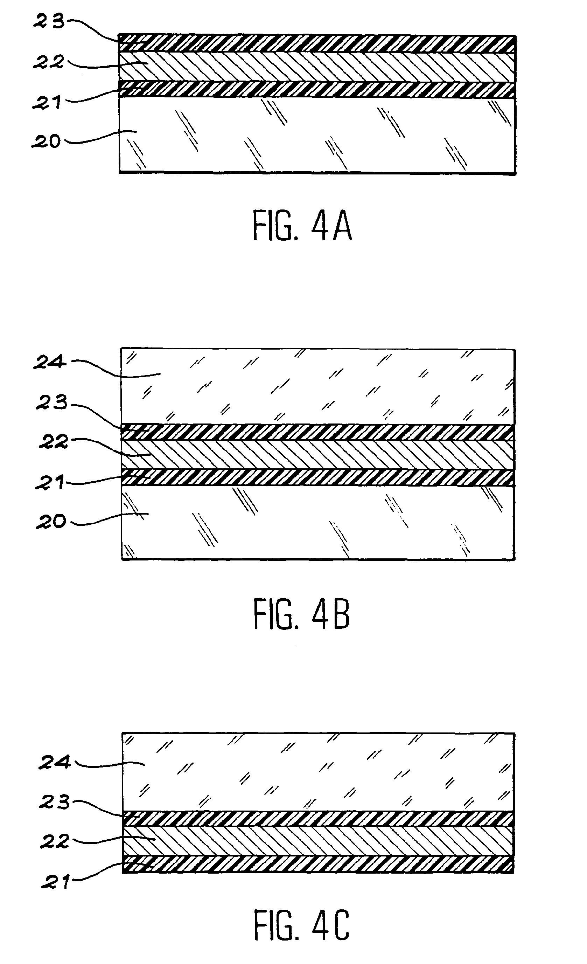

Les figures 4A à 4C sont des vues en coupe transversale qui illustrent une première variante du procédé selon l'invention.

La figure 4A montre un support de fabrication 20 par exemple en silicium, d'épaisseur 500 µm environ. Il s'agit d'une plaquette utilisée couramment en micro-électronique et qui reçoit un nettoyage standard. Une couche 21 de SiO₂ thermique de 200 nm d'épaisseur est fabriqué à la surface du support 20. Cette couche 21 sert de couche d'arrêt. Elle est particulièrement utile si un amincissement mécanique ou mécano-chimique est utilisé par la suite pour éliminer le support de fabrication.

On procède ensuite au dépôt du réflecteur 22 sur la couche d'arrêt 21. Le réflecteur 22 est par exemple constitué de 40 paires de couches Mo/Si en commençant et en finissant par une couche de silicium.

Il peut être avantageux de déposer alors une couche d'adhérence 23 sur l'empilement. Cette couche d'adhérence 23 est par exemple une couche de SiO₂ de type TEOS.

Comme cela est visible sur la figure 4B, un support de réception 24 est collé sur la face libre de la couche d'adhérence 23. Le support de réception 24 peut être un substrat de silice vitreuse ultra-pure à rugosité inférieure à 0,5 nm RMS (valeur quadratique moyenne). Avant le collage, un nettoyage du type hydrophile est par exemple effectué, le collage étant obtenu par adhésion moléculaire. Les forces de collage sont suffisantes dès la température ambiante. Cependant, il est avantageux d'effectuer un recuit à 150°C pendant 4 heures, ce recuit devant être compatible avec le réflecteur. L'énergie de collage après ce traitement et une bonne préparation hydrophile de la surface est de 400 mJ/m². Cette énergie de collage est compatible notamment avec une élimination du support de fabrication par amincissement mécanique ou mécano-chimique.

Le support de fabrication 20 est ensuite éliminé, par exemple par amincissement mécanique ou mécano-chimique avec arrêt sur la couche d'arrêt 21. Dans le cas de l'amincissement mécanique, il est préférable d'arrêter l'opération d'amincissement avant élimination complète du support de fabrication et de terminer par un amincissement chimique. Pour un support de fabrication en silicium, l'amincissement chimique peut être obtenu en utilisant de l'hydroxyde de tétraméthylammonium (TMAH) ou KOH. On obtient la structure représentée à la figure 4C.

La structure obtenue peut alors recevoir, sur la couche d'arrêt 21, une couche absorbante qui sera ensuite gravée, la couche d'arrêt 21 étant alors gravée selon les mêmes motifs. Selon une autre variante, la couche d'arrêt 21 est éliminée avant dépôt et gravure de la couche absorbante.

L'amincissement du support de fabrication peut également être réalisé en utilisant le procédé divulgué par le document FR-A-2 681 472. Dans ce cas, la face du support de fabrication devant être située du côté du réflecteur subit au préalable une implantation ionique, par exemple selon une dose de 1,5 · 10¹⁷ H/cm² afin de créer une couche de microcavités à l'intérieur du support de fabrication et près de sa face implantée. L'amincissement du support de fabrication pourra être ensuite obtenu par un recuit à 150°C pendant 4 heures suivi de l'application d'une force mécanique pour achever le clivage du support. L'intérêt de cette technique est la possibilité de s'affranchir de la couche d'arrêt. Après le clivage, un polissage mécano-chimique permet éventuellement de retrouver une bonne rugosité de surface du film mince laissé sur la structure par le support de fabrication si on désire conserver ce film mince. De la même façon que la couche d'arrêt, le film mince peut être conservé ou éliminé totalement ou partiellement.

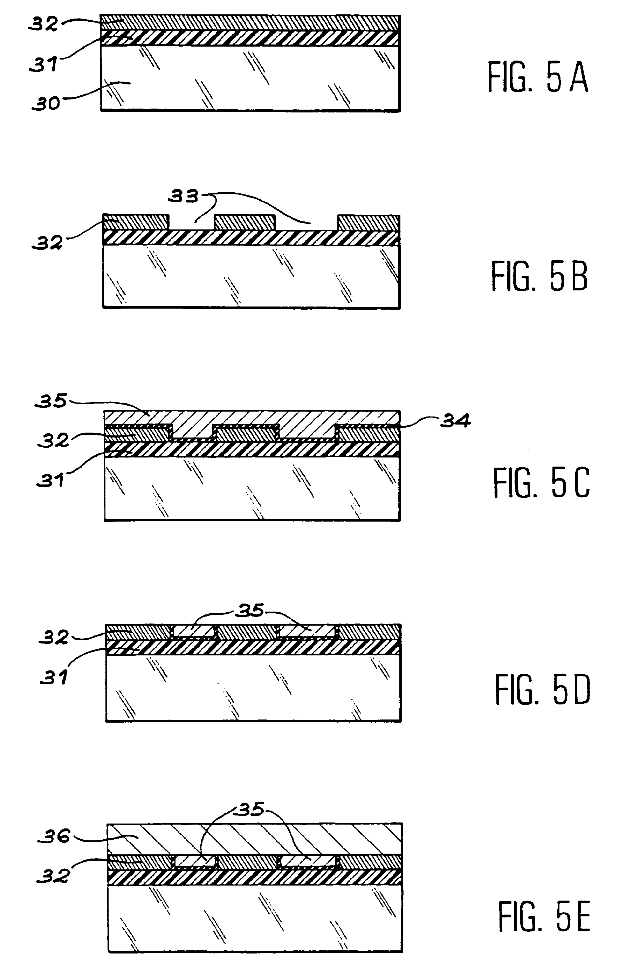

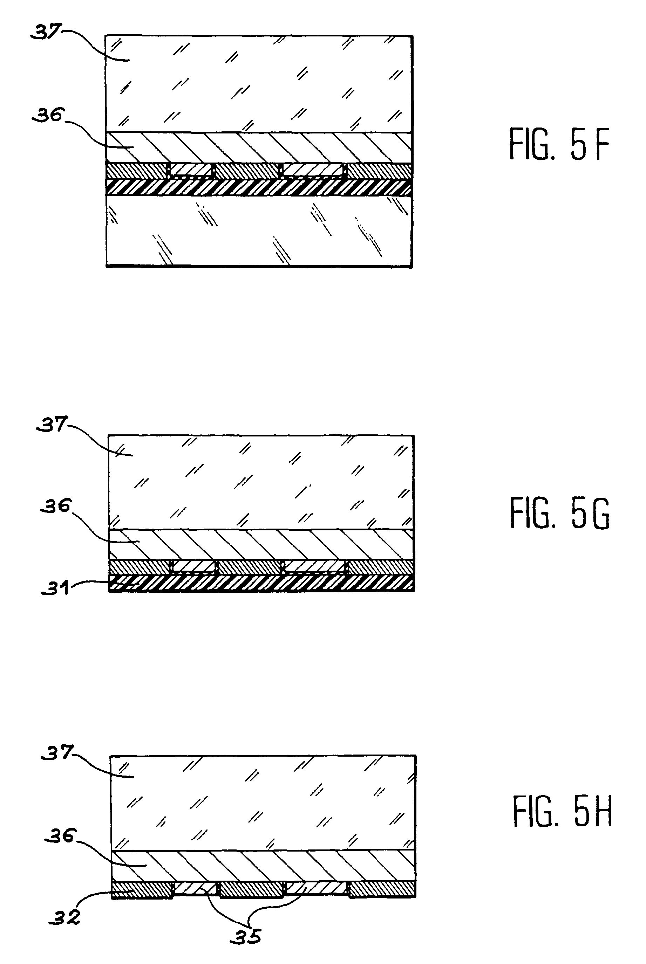

Les figures 5A à 5H sont des vues en coupe transversale qui illustrent une deuxième variante du procédé selon l'invention.

La figure 5A montre un support de fabrication 30 recouvert d'une couche d'arrêt 31 qui peuvent être identiques aux éléments correspondants décrits dans le premier exemple de réalisation. Sur la couche d'arrêt 31, on dépose une couche 32 de silicium polycristallin d'une épaisseur d'environ 200 nm et destinée à définir le motif de la couche absorbante.

Par des techniques connues de l'homme du métier, la couche 32 est gravée. La figure 5B montre des zones 33 gravées dans la couche 32 et révélant la couche d'arrêt 31.

Comme le montre la figure 5C, une mince couche 34, qui est une autre couche d'arrêt en SiO₂, est ensuite déposée. La couche d'arrêt 34 recouvre la couche gravée 32 et les parties révélées de la couche d'arrêt 31 en épousant la forme de la couche gravée 32. Une couche 35 de tungstène destinée à constituer la couche absorbante est ensuite déposée sur la couche d'arrêt 34 en épousant sa forme, c'est-à-dire que du tungstène se trouve dans les parties gravées de la couche 32.

Ensuite, on procède à un polissage mécano-chimique de la couche de tungstène 35 jusqu'à la couche d'arrêt 34 qui est ensuite éliminée au-dessus de la couche 32. Le résultat obtenu est visible sur la figure 5D.

On procède ensuite au dépôt du réflecteur 36 sur l'empilement obtenu précédemment (voir la figure 5E). Le réflecteur 36 est par exemple constitué de 40 paires de couches Mo/Si en commençant et en finissant par une couche de silicium.

Un support de réception 37 est ensuite collé sur le réflecteur 36. Le collage est avantageusement obtenu par adhésion moléculaire mais peut aussi être réalisé à partir d'une substance adhésive. Le support de réception peut être un substrat de silice vitreuse ultra-pure. Le résultat obtenu est visible sur la figure 5F.

Le support de fabrication est ensuite éliminé. Cette élimination peut être réalisée de la même manière que pour la première variante du procédé selon l'invention. Le résultat obtenu est visible sur la figure 5G.

L'élimination du support de fabrication révèle la couche d'arrêt 31 qui est ensuite éliminée comme pour la première variante du procédé selon l'invention. Cette élimination peut inclure la partie de la couche d'arrêt 34 encore présente sur la couche absorbante 35. La couche 32 restante peut alors être éliminée ou conservée en fonction de ses propriétés optiques pour dégager le réflecteur 36.

La réalisation du multicouche réflecteur sur un support de fabrication qui n'est pas le support final procure un certain nombre d'avantages. Un premier avantage est de réaliser le multicouche sur un substrat de silicium dont on maîtrise bien les procédés de nettoyage. L'invention permet ensuite le transfert de la partie active du masque sur un support en verre à faible coefficient de dilatation, par exemple un verre de silice, en ZERODUR^{®} commercialisé par Schott ou en ULE^{®} commercialisé par Corning, ou encore en SiC. Le procédé de réalisation du multicouche mis au point sur un support ne nécessite pas d'adaptation si un autre support final est choisi pour le masque.

L'invention permet de réaliser la couche absorbante, et éventuellement de la graver, sur le support de fabrication sans contrainte technologique due à la présence du multicouche. Il n'y a par exemple pas de contrainte en température imposée par le multicouche dont les performances optiques sont détériorées au delà d'une température qui dépend du type d'empilement (pour un empilement Mo/Si, la température limite est de 200°C). L'invention procure aussi une plus grande latitude dans le choix des procédés pour réaliser la couche absorbante et sa gravure.

## Revendications

1. Structure pour masque de lithographie en réflexion **caractérisée en ce qu'**elle comporte un support de réception (12,24,37) sur lequel est fixé un réflecteur (11,22,36) comprenant au moins une couche, le réflecteur étant fixé au support de réception de manière inversée par rapport à un support de fabrication (10,20,30) sur lequel il a été précédemment fabriqué.

2. Structure selon la revendication 1, **caractérisée en ce que** le réflecteur (11,22,36) est un multicouche.

3. Structure selon la revendication 2, **caractérisée en ce que** le multicouche est formé d'une alternance de couches de molybdène et de silicium.

4. Structure selon la revendication 1, **caractérisée en ce que** le réflecteur (22) est fixé au support de réception (24) par l'intermédiaire d'une couche d'adhérence (23).

5. Structure selon la revendication 1, **caractérisée en ce que** le réflecteur (36) ayant été fabriqué sur un support de fabrication (30) recouvert d'une couche absorbante (32) pour la longueur d'onde de la source de rayonnement de lithographie utilisé, le réflecteur (36) et la couche absorbante (32) peuvent être fixés au support de réception (37) de manière inversée par rapport au support de fabrication (30).

6. Structure selon la revendication 5, **caractérisée en ce que** la couche absorbante (32) recouvrant le support de fabrication (30) est une couche gravée selon un motif de masque désiré.

7. Structure selon l'une quelconque des revendications 1 à 6, **caractérisée en ce que** le support de réception (12,24,37) est un substrat de faible coefficient de dilatation.

8. Procédé de réalisation d'une structure pour masque de lithographie en réflexion, **caractérisé en ce qu'**il comporte les étapes suivantes :
- réalisation d'un réflecteur (11,22,36) sur un support de fabrication (10,20,30),
- fixation d'un support de réception (12,24,37) sur le réflecteur,
- élimination au moins partielle du support de fabrication.

9. Procédé selon la revendication 8, **caractérisé en ce que** le réflecteur (11,22,36) est réalisé sous forme d'un multicouche.

10. Procédé selon l'une des revendications 8 ou 9, **caractérisé en ce qu'**il comprend une étape préliminaire de formation d'une couche absorbante (32), pour la longueur d'onde de la source de rayonnement de lithographie utilisé, sur le support de fabrication (30) avant la réalisation du réflecteur (36).

11. Procédé selon la revendication 8, **caractérisé en ce que** la fixation du support de réception (12,24,37) sur le réflecteur (11,22,36) se fait par adhésion moléculaire

12. Procédé selon la revendication 11, **caractérisé en ce qu'**une couche d'adhérence (23) est utilisée pour fixer le support de réception (24) sur le réflecteur (22).

13. Procédé selon la revendication 8, **caractérisé en ce que** l'élimination du support de fabrication s'effectue par amincissement mécanique et/ou mécano-chimique et/ou chimique.

14. Procédé selon la revendication 13, **caractérisé en ce que,** le support de fabrication (30) étant pourvu, côté réflecteur (36), d'une couche d'arrêt (31), l'amincissement s'effectue jusqu'au contact avec la couche d'arrêt.

15. Procédé selon la revendication 13, **caractérisé en ce que,** l'élimination du support de fabrication utilisant l'amincissement mécanique, l'amincissement mécanique est arrêté avant élimination complète du support de fabrication, l'élimination étant poursuivie ensuite par voie chimique.

16. Procédé selon la revendication 8, **caractérisé en ce que** le support de fabrication comportant, côté réflecteur, une couche sacrificielle, l'élimination du support de fabrication se fait par gravure sélective de la couche sacrificielle.

17. Procédé selon la revendication 8, **caractérisé en ce que** le support de fabrication est un substrat dont une face, destinée à être située côté réflecteur, a été implantée par des espèces gazeuses afin de former une couche de microcavités dans le substrat et à proximité de la face implantée, l'élimination du support de fabrication comprenant l'application d'un recuit et/ou de force mécanique pour obtenir le clivage du substrat de fabrication le long de la couche de microcavités.

## Claims

1. A structure for a lithographic reflection mask **characterised in that** it comprises a receive medium (12, 24, 37) on which is fixed a reflector (11, 22, 36) including at least one layer, the reflector being fixed to the receive medium in a reverse manner relative to a manufacturing medium (10, 20, 30) on which it has been previously manufactured.

2. A structure according to claim 1, **characterised in that** the reflector (11, 22, 36) is a multi-layer.

3. A structure according to claim 2, **characterised in that** the multi-layer is formed of an alternation of layers of molybdenum and silicon.

4. A structure according to claim 1, **characterised in that** the reflector (22) is fixed to the receive medium (24) by means of a bonding layer (23).

5. A structure according to claim 1, **characterised in that** the reflector (36) having been manufactured on a manufacturing medium (30) coated with an absorbent layer (32) for the wavelength of the source of lithographic radiation used, the reflector (36) and the absorbent layer (32) may be fixed to the receive medium (37) in a reverse manner relative to the manufacturing medium (30).

6. A structure according to claim 5, **characterised in that** the absorbent layer (32) coating the manufacturing medium (30) is an engraved layer according to a desired mask pattern.

7. A structure according to any one of claims 1 to 6, **characterised in that** the receive medium (12, 24, 37) is a substrate of low coefficient of expansion.

8. A process for manufacturing a structure for a lithographic reflection mask, **characterised in that** it comprises the following stages:
- making a reflector (11, 22, 36) on a manufacturing medium (10, 20, 30),
- fixing a receive medium (12, 24, 37) on the reflector,
- at least partly eliminating the manufacturing medium.

9. A process according to claim 8, **characterised in that** the reflector (11, 22, 36) is made in the form of a multi-layer.

10. A process according to one of the claims 8 or 9, **characterised in that** it includes a preliminary stage of formation of an absorbent layer (32), for the wavelength of the source of lithographic radiation used, on the manufacturing medium (30) before the reflector (36) is made.

11. A process according to claim 8, **characterised in that** the fixing of the receive medium (12, 24, 37) on the reflector (11, 22, 36) is achieved by molecular adhesion.

12. A process according to claim 11, **characterised in that** a bonding layer (23) is used to fix the receive medium (24) on the reflector (22).

13. A process according to claim 8, **characterised in that** elimination of the manufacturing medium is carried out by mechanical and/or mechanical-chemical and/or chemical thinning.

14. A process according to claim 13, **characterised in that,** the manufacturing medium (30) being provided, reflector side (36), with a barrier layer (31), the thinning is carried out until contact is made with the barrier layer.

15. A process according to claim 13, **characterised in that,** the manufacturing medium being eliminated using mechanical thinning, the mechanical thinning is stopped before complete elimination of the manufacturing medium, the elimination being then continued chemically.

16. A process according to claim 8, **characterised in that** the manufacturing medium comprising, reflector side, a sacrificial layer, the elimination of the manufacturing medium is achieved by selective engraving of the sacrificial layer.

17. A process according to claim 8, **characterised in that** the manufacturing medium is a substrate one face of which, intended to be located on the reflector side, has been implanted by gaseous radicals so as to form a layer of microcavities in the substrate and in proximity to the implanted face, the elimination of the manufacturing medium including the application of an anneal and/or mechanical force to obtain the cleavage of the manufacturing substrate along the layer of microcavities.

## Patentansprüche

1. Lithographische Reflexionsmaskenstruktur,
**dadurch gekennzeichnet, dass** sie einen Aufnahmeträger (12,24,37) umfasst, auf dem ein Reflektor (11,22,36) befestigt ist, der wenigstens eine Schicht umfasst, wobei der Reflektor an dem Aufnahmeträger in umgekehrter Weise befestigt ist, bezogen auf einen Herstellungsträger (10,20,30), auf dem er vorher hergestellt worden ist.

2. Struktur nach Anspruch 1, **dadurch gekennzeichnet, dass** der Reflektor (11,22,36) eine Multischicht ist.

3. Struktur nach Anspruch 2, **dadurch gekennzeichnet, dass** die Multischicht durch eine Wechselfolge von Molybdän- und Siliciumschichten gebildet wird.

4. Struktur nach Anspruch 1, **dadurch gekennzeichnet, dass** der Reflektor (22) an dem Aufnahmeträger (24) mittels einer Haftschicht (23) befestigt ist.

5. Struktur nach Anspruch 1, **dadurch gekennzeichnet, dass** der Reflektor (36) auf einem Herstellungsträger (30) hergestellt worden ist, der überzogen ist mit einer die Wellenlänge der verwendeten Lithographiestrahlungsquelle absorbierenden Schicht (32), wobei der Reflektor (36) und die absorbierende Schicht (32) an dem Aufnahmeträger (37) in Bezug auf den Herstellungsträger (30) in umgekehrter Weise befestigt sein können.

6. Struktur nach Anspruch 5, **dadurch gekennzeichnet, dass** die den Herstellungsträger (30) bedeckende absorbierende Schicht (32) eine gemäß einem gewünschten Maskenmuster geätzte Schicht ist.

7. Struktur nach einem der Ansprüche 1 bis 6, **dadurch gekennzeichnet, dass** der Aufnahmeträger (12,24,37) ein Substrat mit einem niedrigen Wärmedehnungskoeffizienten ist.

8. Verfahren zur Realisierung einer lithographischen Reflexionsmaskenstruktur,
**dadurch gekennzeichnet, dass** es die folgenden Schritte umfasst:
- Realisierung eines Reflektors (11,22,36) auf einem Herstellungsträger (10,20,30),
- Befestigung eines Empfangsträgers (12,24,37) an dem Reflektor,
- Eliminierung wenigstens eines Teils des Herstellungsträgers.

9. Verfahren nach Anspruch 8, **dadurch gekennzeichnet, dass** der Reflektor (11,22,36) in Form einer Multischicht realisiert wird.

10. Verfahren nach einem der Ansprüche 8 oder 9, **dadurch gekennzeichnet, dass** es, vor der Realisierung des Reflektors (36), einen Vorausschritt zu Bildung einer die Wellenlänge der benutzten Lithographiestrahlungsquelle absorbierenden Schicht (32) auf dem Herstellungsträger (30) umfasst.

11. Verfahren nach Anspruch 8, **dadurch gekennzeichnet, dass** die Befestigung des Empfangsträgers (12,24,37) auf dem Reflektor (11,22,36) durch Molekularadhäsion erfolgt.

12. Verfahren nach Anspruch 11, **dadurch gekennzeichnet, dass** die Haftschicht (23) benutzt wird, um den Aufnahmeträger (24) auf dem Reflektor (22) zu befestigen.

13. Verfahren nach Anspruch 8, **dadurch gekennzeichnet, dass** die Eliminierung des Herstellungsträgers durch mechanische und/oder mechanisch-chemische und/oder chemische Dünnmachung erfolgt.

14. Verfahren nach Anspruch 13, **dadurch gekennzeichnet, dass** der Herstellungsträger (30) auf seiner dem Reflektor (36) zugewandten Seite eine Stoppschicht (31) aufweist und die Dünnmachung bis zum Kontakt mit dieser Stoppschicht erfolgt.

15. Verfahren nach Anspruch 13, **dadurch gekennzeichnet, dass** die Eliminierung des Herstellungsträgers durch die mechanische Dünnmachung vor der vollständigen Eliminierung des Herstellungsträgers gestoppt wird und die Eliminierung dann auf chemischem Wege fortgesetzt wird.

16. Verfahren nach Anspruch 8, **dadurch gekennzeichnet, dass** der Herstellungsträger auf der dem Reflektor zugewandten Seite eine Opferschicht umfasst und die Eliminierung durch selektive Ätzung der Opferschicht erfolgt.

17. Verfahren nach Anspruch 8, **dadurch gekennzeichnet, dass** der Herstellungsträger ein Substrat ist, dessen eine, dem Reflektor zugewandte Seite mit gasförmigen Spezies implantiert worden ist, um in dem Substrat nahe der Implantierungsseite eine Schicht mit Mikrohohlräumen auszubilden, wobei die Eliminierung des Herstellungsträgers die Anwendung einer Temperung und/oder von mechanischen Kräften umfasst, um die Spaltung des Herstellungssubstrats längs der Mikrohohlräume-Schicht zu bewirken.
